# EUROPEAN PATENT APPLICATION

(11) **EP 4 148 788 A1**
(43) Date of publication of application: **15.03.2023**
(21) Application number: 22190215.8
(22) Date of filing: 12.08.2022
(51) Int. Cl.: H01L 25/065

(54) **MULTI-DIE PACKAGE WITH PLURAL MESHED FIRST DIES AND ACTIVE BRIDGING CHIPLETS**

(30) Priority: 13.09.2021 US 202117473162
(71) Applicant: INTEL Corporation, Santa Clara, CA 95054 (US)
(72) Inventor: KARNIK, Tanay, Portland, 97229 (US); KURIAN, Dileep, Portland, 97124 (US); JACKSON, Bradley, Lake Oswego, 97035 (US); RANGACHAR SRINIVASA, Srivatsa, Hillsboro, 97124 (US); SUNDARAM PRIYA, Jainaveen, Hillsboro, 97123 (US); ELSHERBINI, Adel, Chandler, 85248 (US)
(74) Representative: 2SPL Patentanwälte PartG mbB

(57) **Abstract**

Embodiments disclosed herein include die modules. In an embodiment, a die module comprises a plurality of first dies, and a second die under the plurality of first dies. In an embodiment, the second die is coupled to individual ones of the plurality of first dies. In an embodiment, the second die comprises a plurality of mesh stops, and conductive routing to electrically couple the mesh stops together.

## Description

### TECHNICAL FIELD

Embodiments of the present disclosure relate to electronic packages, and more particularly to electronic packages with chiplets that provide a disaggregated mesh and L4 cache.

### BACKGROUND

As electronic packaging architectures continue to advance, there is a move in the industry away from monolithic die architectures to disaggregated chiplet architectures. The separation into chiplets is based on die size limitations, functions, and process capabilities. In the case of monolithic dies, on-die mesh or ring structures were used to interconnect various parts of the chip. These interconnects have to span across die-to-die (D2D) interfaces in chiplets. The overall solutions to die disaggregation should perform similar to the monolithic implementations. D2D transmitters (Tx), receivers (Rx), clocking circuits, matched routing channels, and power delivery units are needed to provide the coupling between the individual chiplets. Currently, this additional circuitry is provided on the chiplets, and wastes valuable real estate on advanced process node devices.

In some instances a single base die is provided below the chiplets in order to provide connections between each of the chiplets. In such an implementation, the channels are offloaded from the chiplets to the base die, but the rest of the active circuitry is provided on the overlying chiplets. In other instances, embedded bridge architectures are used to provide connections between chiplets. However, embedded bridges typically only include conductive lines. That is, there is no active circuitry in the embedded bridge, and the active circuitry remains on the chiplets. Such systems therefore result in wasted space on the top chiplets. This also incurs power and area penalties. The length of the D2D channels are also limited.

### BRIEF DESCRIPTION OF THE DRAWINGS

Figure 1A is a plan view illustration of a die module with dies that are coupled together by embedded bridges in an underlying package substrate.
Figure 1B is a plan view illustration of a die module with a plurality of dies that are coupled together by a base die.
Figure 2A is a cross-sectional illustration of a die module with dies that are coupled together by underlying dies with active circuitry, in accordance with an embodiment.
Figure 2B is a cross-sectional illustration of a die module with dies that are coupled together by underlying dies with active circuitry without a base die, in accordance with an embodiment.
Figure 3 is a cross-sectional illustration of a hybrid bonding interconnect interface between a pair of dies, in accordance with an embodiment.
Figure 4A is a plan view illustration of a die module with a die that couples together a plurality of overlying dies, in accordance with an embodiment.
Figure 4B is a plan view illustration of the hub die with a plurality of mesh stops, in accordance with an embodiment.
Figure 4C is a plan view illustration of the hub die with a plurality of mesh stops and memory blocks, in accordance with an embodiment.
Figure 5A is a cross-sectional illustration of a die module with a hub die for connecting together overlying dies and bridge dies for coupling the overlying dies to IO dies, in accordance with an embodiment.
Figure 5B is a cross-sectional illustration of a die module with a hub die without an underlying base die, in accordance with an embodiment.
Figure 5C is a cross-sectional illustration of a die module with a stack of memory dies below the overlying dies, in accordance with an embodiment.
Figure 6 is a cross-sectional illustration of an electronic system with disaggregated dies coupled together by a hub die, in accordance with an embodiment.
Figure 7 is a schematic of a computing device built in accordance with an embodiment.

### EMBODIMENTS OF THE PRESENT DISCLOSURE

Described herein are electronic packages with chiplets that provide a disaggregated mesh and L4 cache, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

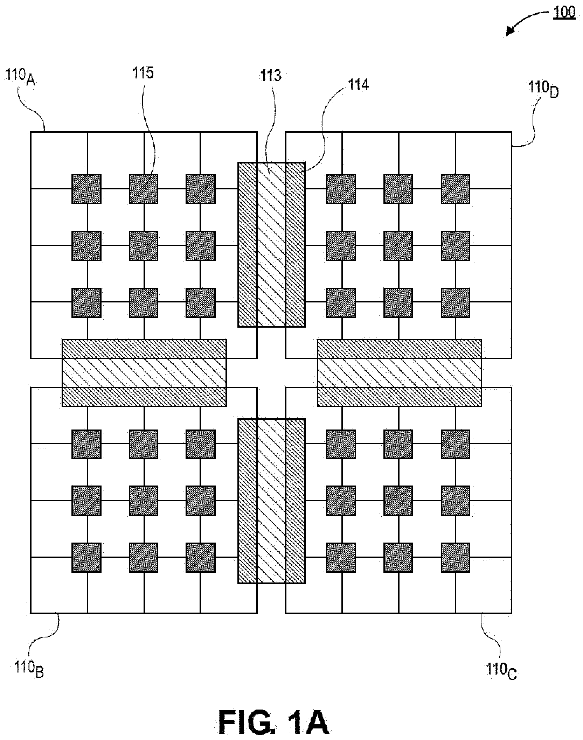

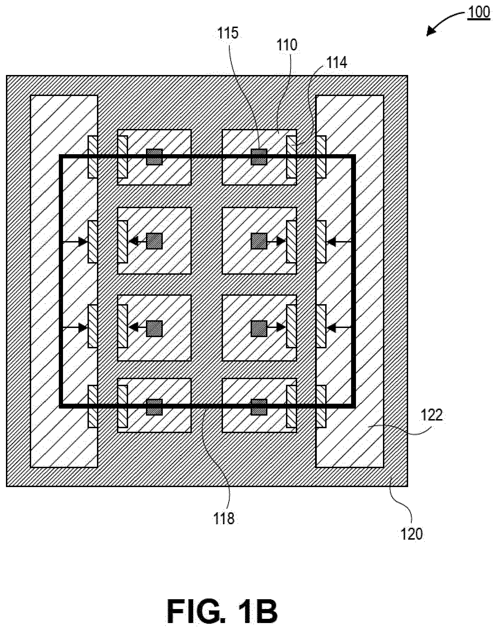

As noted above, die disaggregation is beneficial as it accommodates die size limitations, functions, and process capabilities. However, the disaggregation of a monolithic die into smaller dies (also sometimes referred to as chiplets) increases the complexity of providing communication pathways between the dies. Figures 1A and 1B provide illustrations of some disaggregation architectures.

Referring now to Figure 1A, a plan view illustration of a die module 100 is shown. The die module 100 may include a plurality of dies 110_{A}-110_{D} that are arranged in an array. While four dies 110 are shown, it is to be appreciated that any number of dies 110 may be provided in an array. Each of the dies 110 may comprise one or more mesh stops 115 (also sometimes referred to as cache home agents (CHA)). Communication fabric interface 114 may be provided at the edge of the dies 110. Bridges 113 may connect the adjacent fabric interfaces 114 on neighboring dies 110. The bridges 113 may be embedded in an underlying package substrate (not shown).

As shown, the mesh stops 115 and interface fabric 114 are provided on the overlying dies 110. Such mesh stops 115 and interface fabric 114 may include active circuitry for transmitters (Tx), receivers (Rx), clocking circuits, matched routing channels, and power delivery units. In some instances where the die 110 is an advanced process node die (e.g., a processor, a graphics processor, or the like) the mesh stops 115 and the interface fabric 114 may be at a less advanced process node. As such, a significant area of the die 110 is occupied by the mesh stops 115 and the interface fabric 114.

Furthermore, it is to be appreciated that existing architectures do not allow for the offloading of the mesh stops 115 and the interface fabric 114 to the underlying bridge 113. This is because the bridge 113 is typically a passive device that only includes conductive traces in order to provide a communication link between the dies 110.

Referring now to Figure 1B, a plan view illustration of an alternative architecture die module 100 is shown. Instead of using discrete bridges 113 to couple together the overlying dies 110, a base die 120 is used. The base die 120 may have a footprint that is larger than the overlying dies 110 and IO dies 122. In the illustrated embodiment, the fabric loop 118 is shown. The fabric loop 118 is long and extends below the IO dies 122. Therefore, in order to communicate with each other, the dies 110 must propagate a signal along a longer path, which is detrimental to device performance.

Accordingly, embodiments disclosed herein include die module architectures with disaggregated dies that are communicatively coupled by underlying communication dies. The underlying communication dies may be chiplets or hub dies. A chiplet may be a smaller die that couples together a pair of overlying dies. A hub die may be a die that couples together a plurality of overlying dies. In various embodiments, communication functionality (e.g., mesh stops and fabric interfaces) are offloaded onto the underlying communication hub die or chiplets. As such, valuable real estate on the overlying dies is preserved since it is not needed for communication functionality.

In some embodiments, the communication dies may be provided between a base die and the overlying disaggregated dies. In other embodiments, the base die may be omitted. Furthermore, embodiments may include additional memory blocks provided on the communication dies. That is, the communication dies may have additional space that is not occupied by the communication circuitry, and the additional space may be occupied by memory blocks. For example level 4 (L4) cache may be provided on the communication dies in some embodiments. In yet another embodiment, high density interconnects are provided between various components of the die module. The high density interconnects may include hybrid bonding interconnect (HBI) interface architectures. In such embodiments, the bump pitch of the HBI interface may be approximately 20µm or smaller, or approximately 10µm or smaller.

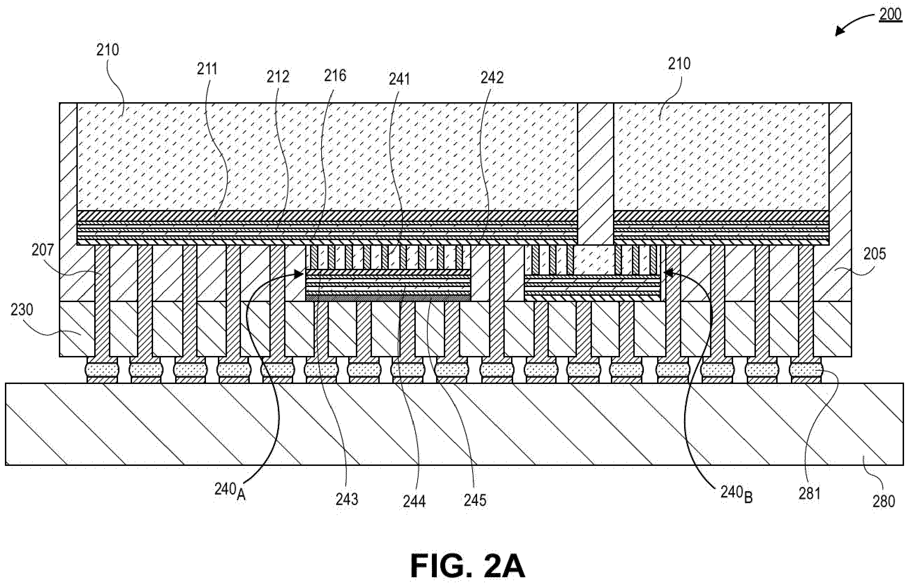

Referring now to Figure 2A, a cross-sectional illustration of a die module 200 is shown, in accordance with an embodiment. In an embodiment, the die module 200 may be coupled to a package substrate 280 by interconnects 281. The interconnects 281 may be solder balls or any other interconnect architecture. In an embodiment, the die module 200 may comprise disaggregated dies 210, communication dies 240, and a base die 230. The disaggregated dies 210 may be any type of die (e.g., CPU, GPU, accelerator, etc.). The communication dies 240 may communicatively couple the disaggregated dies 210 together.

In an embodiment, the disaggregated dies 210 may include an active circuitry layer 211 in a die substrate. The active circuitry layer 211 may include transistors and the like in order to provide logic, memory, or any other active circuitry functionality to the disaggregated die 210. The die substrate is a semiconductor substrate. For example, the die substrate may comprise silicon, or other semiconductor materials.

In an embodiment, routing layers 212 (sometimes referred to as metal layers (e.g., M0, M1, M2, etc.)) may be provided on the active circuitry layer 211. In an embodiment, the routing layers 212 may comprise copper or any other conductive material or materials suitable for semiconductor dies. In an embodiment, bottom layers of the disaggregated dies 210 in Figure 2A may be interconnect layers 216. The interconnect layers 216 may be any suitable type of interconnect architecture. For example, first level interconnects (FLIs) may be provided as part of the interconnect layers 216. In a particular embodiment, the interconnect layers 216 may be suitable for hybrid bonding interconnect (HBI) interfaces. HBI interfaces will be described in greater detail below.

In an embodiment, a pair of communication dies 240_{A} and 240_{B} are shown. However, it is to be appreciated that any number of communication dies 240 may be included in the die module 200. For example, a single communication die 240 may be used when a hub die approach is used (as will be described in greater detail below). Other embodiments may include more than two communication dies 240. It is to be appreciated that, while referred to as "communication dies", the communication functionality may be limited to communication between disaggregated dies 210 within the die module. That is, communication to systems outside of the die module 200 (e.g., using wireless communication protocols) may be implemented with a separate communication chip that may be one of the disaggregated dies 210.

In an embodiment, the communication dies 240_{A} and 240_{B} may have a substrate 242. The substrate 242 may be a semiconductor substrate. For example, the substrate 242 may comprise silicon or any other semiconductor material or materials. In an embodiment, vias 241 may be provided through a portion of the substrate 242. The vias 241 may be coupled with the interconnect layers 216 of the overlying disaggregated dies 210. In the communication die 240_{A}, the opposite end of the vias 241 may be coupled to an active circuitry layer 243.

In an embodiment, the active circuitry layer 243 may include circuitry in order to offload mesh stops and/or interface fabric from the disaggregated dies 210. For example, the active circuitry layer 243 may include transmitters (Tx), receivers (Rx), clocking circuits, matched routing channels, and power delivery units to provide the coupling between the individual disaggregated dies 210. As such, valuable real estate on the disaggregated dies 210 can be preserved.

In an embodiment, routing layers 244 may be provided in the substrate 242. In the communication die 240_{A}, the routing layers 244 are on the active circuitry layer 243, and in the communication die 240_{B}, the routing layers 244 are directly coupled to the vias 241. An interconnect layer 245 may be provided on the routing layers 244. The interconnect layer 245 may be a first level interconnect (FLI) architecture. For example, the interconnect layer 245 may comprise micro bumps, HBI interfaces, or the like.

In an embodiment, the die module 200 may be embedded in a mold layer 205. The mold layer 205 may be disposed over the base die 230 and surround the communication dies 240 and the disaggregated dies 210. A backside surface of the disaggregated dies 210 may be exposed. In an embodiment, vias 207 may pass through the mold layer 205 and/or the base die 230. The vias 207 may couple the disaggregated dies 210 and the communication dies 240 to the interconnects 281.

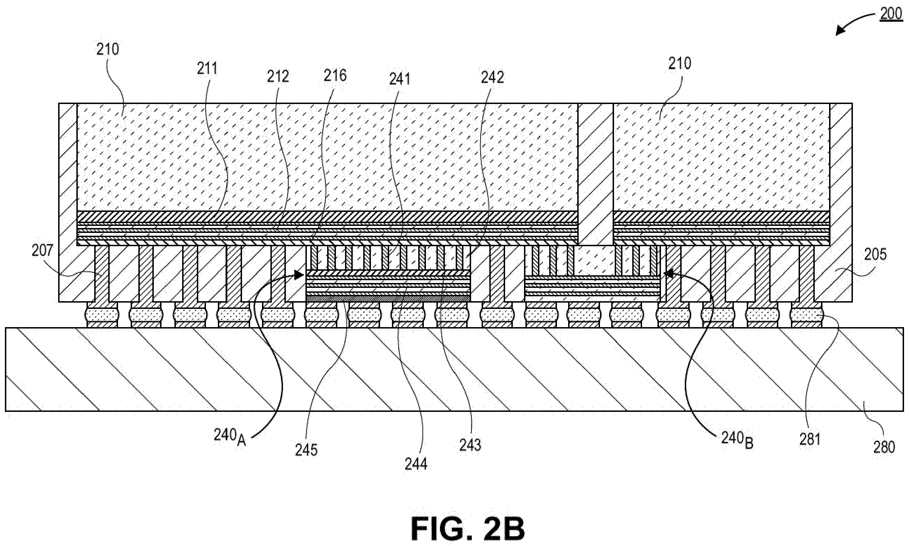

Referring now to Figure 2B, a cross-sectional illustration of a die module 200 is shown, in accordance with an additional embodiment. In an embodiment, the die module 200 may be coupled to a package substrate 280 by interconnects 281. The die module 200 in Figure 2B may be substantially similar to the die module 200 in Figure 2A, with the exception of the base die 230 being omitted. Instead, the bottom surface of the mold layer 205 may be coupled to the package substrate 280 by the interconnects 281. Additionally, the communication dies 240_{A} and 240_{B} may be coupled directly to the package substrate 280 by interconnects 281 without the need for vias 207.

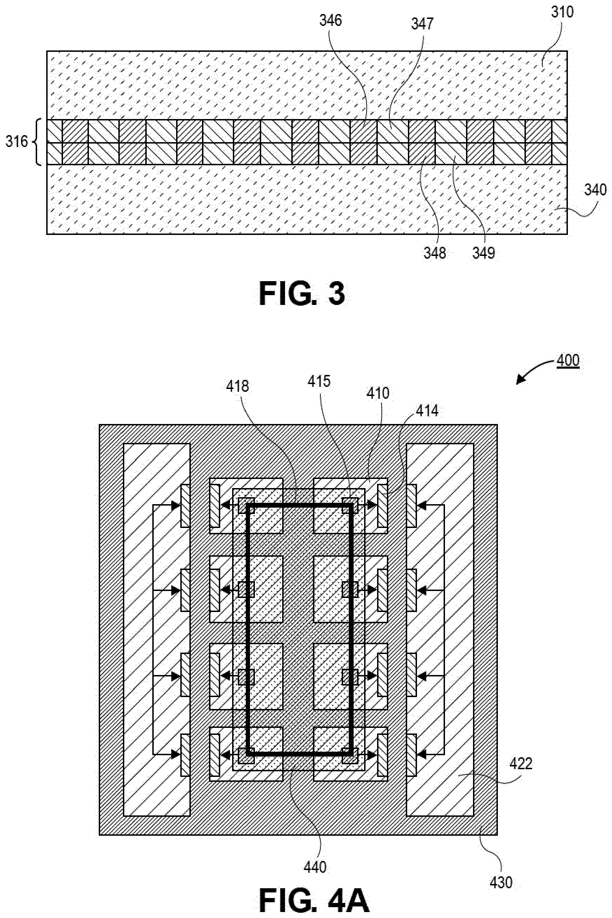

Referring now to Figure 3, a cross-sectional illustration of an interconnect interface 316 is shown, in accordance with an embodiment. The interconnect interface 316 couples together a first die 310 and a second die 340. For example, the first die 310 may be a disaggregated die, and the second die 340 may be a communication die, similar to the dies described in greater detail above. In an embodiment, the interconnect interface 316 is an HBI interface.

In an embodiment, the first die 310 may comprise a plurality of first bumps 346. The first bumps 346 may comprise copper or other conductive materials. In an embodiment, the first bumps 346 have a fine pitch. For example, HBI interfaces may be able to support first bumps 346 with a pitch that is approximately 20µm or smaller, or approximately 10µm or smaller. In an embodiment a first dielectric layer 347 surrounds the first bumps 346. The first dielectric layer 347 may be any suitable dielectric for hybrid bonding. For example, the first dielectric layer 347 may comprise silicon and oxygen (e.g., SiOx).

In an embodiment, the second die 340 may comprise a plurality of second bumps 348. The second bumps 348 may comprise copper or other conductive materials. In an embodiment, the second bumps 348 have a fine pitch that matches the pitch of the first bumps 346. For example, the second bumps 348 may have a pitch that is approximately 20µm or smaller, or approximately 10µm or smaller. In an embodiment a second dielectric layer 349 surrounds the second bumps 348. The second dielectric layer 349 may be any suitable dielectric for hybrid bonding. For example, the second dielectric layer 349 may comprise silicon and oxygen (e.g., SiOx).

In an embodiment, a hybrid bonding process is used to connect the first die 310 to the second die 340. The hybrid bonding process may begin with a low temperature bonding operation. During the low temperature bonding, the first dielectric layer 347 bonds with the second dielectric layer 349. Thereafter, a high temperature bonding process is implemented. During the high temperature bonding process, the first bumps 346 bond with the second bumps 348. Particularly, the first bumps 346 and the second bumps 348 may experience interdiffusion bonding. In the illustrated embodiment, the first bumps 346 and the second bumps 348 have a defined interface boundary. However, in some embodiments, there may not be a discernable interface boundary between the first bumps 346 and the second bumps 348. That is, a single conductive pillar may be provided between the first die 310 and the second die 340 in some embodiments.

Referring now to Figure 4A, a plan view illustration of a die module 400 is shown, in accordance with an embodiment. In an embodiment, the die module 400 may comprise a plurality of disaggregated dies 410. The disaggregated dies 410 may comprise any type of die, such as CPUs, GPUs, accelerators, and the like. In an embodiment, IO dies 422 may be adjacent to the disaggregated dies 410. The IO dies 422 may be coupled to the disaggregated dies 410 over a base die 430. The fabric interfaces 414 may be at the edge of the disaggregated dies 410 and the IO dies 422 to enable the connection between the disaggregated dies 410 and the IO dies 422. The base die 430 may have a footprint that is greater than the combined perimeter of the disaggregated dies 410 and the IO dies 422.

In an embodiment, the disaggregated dies 410 may be communicatively coupled to each other through a hub die 440. The hub die 440 may be between the base die 430 and the disaggregated dies 410. The hub die 440 may have a footprint that is smaller than a combined footprint of the disaggregated dies 410. In an embodiment, the mesh stops 415 may be implemented on the hub die 440. In an embodiment, active circuitry on the hub die 440 may include transmitters (Tx), receivers (Rx), clocking circuits, matched routing channels, and power delivery units. As such, circuitry can be offloaded from the disaggregated dies 410.

In an embodiment, a fabric loop 418 is provided entirely within the hub die 440. This shrinks the length of the fabric loop 418 compared to the fabric loop 118 described with respect to Figure 1B. Accordingly, the performance of the die module 400 is improved since signals do not need to travel as far.

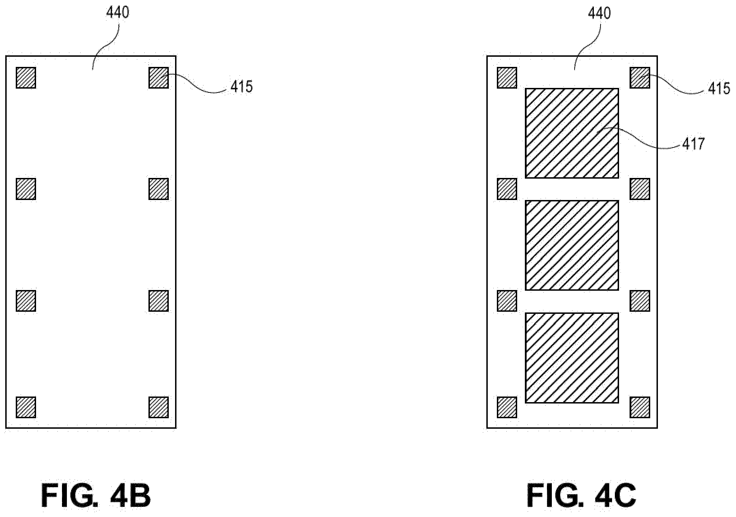

Referring now to Figure 4B, a plan view illustration of a hub die 440 is shown, in accordance with an embodiment. In an embodiment, the hub die 440 may comprise a semiconductor substrate. For example, the hub die 440 may comprise silicon or any other suitable semiconductor material. In an embodiment, the hub die 440 comprise an active circuitry layer. The active circuitry layer may include circuitry for a plurality of mesh stops 415. In the illustrated embodiment, a mesh stop is provided for each of the overlying disaggregated dies (not shown in Figure 4B). However, it is to be appreciated that any number of mesh stops may be provided on the hub die 440 in other embodiments.

In an embodiment, the hub die 440 may also include conductive routing (not visible in Figure 4B). The conductive routing allows for signals to pass between disaggregated dies across the hub die 440. In an embodiment, the connections to the disaggregated dies may be made using any suitable interconnect architecture. In some embodiments, FLIs such as HBI interfaces are used to couple the hub die 440 to the disaggregated dies.

Referring now to Figure 4C, a plan view illustration of a hub die 440 is shown, in accordance with an additional embodiment. The hub die 440 in Figure 4C may be substantially similar to the hub die 440 in Figure 4B, with the exception of additional memory blocks 417 being provided on the hub die 440. Typically, fabric and physical circuitry for the routing of signals between disaggregated dies do not occupy the entire die area of the hub die 440. As such, the remaining area can be utilized to provide additional memory to the system. In a particular embodiment, the memory blocks 417 may be L4 cache memory. Hybrid bonding technology enables a large multi-gigabyte L4 cache that is very close to the overlying disaggregated dies (e.g., CPU, GPU, etc.). The overall solution provides higher performance and drastically reduces compute to memory interface power due to shortened distances of interconnects.

In Figure 4C, three memory blocks 417 are provided. However, it is to be appreciated that any number of memory blocks 417 may be provided in the hub die 440. For example, a single memory block 417 may be used, or two or more memory blocks 417 may be used. In an embodiment, the memory blocks 417 may be implemented in the active circuitry layers of the hub die 440.

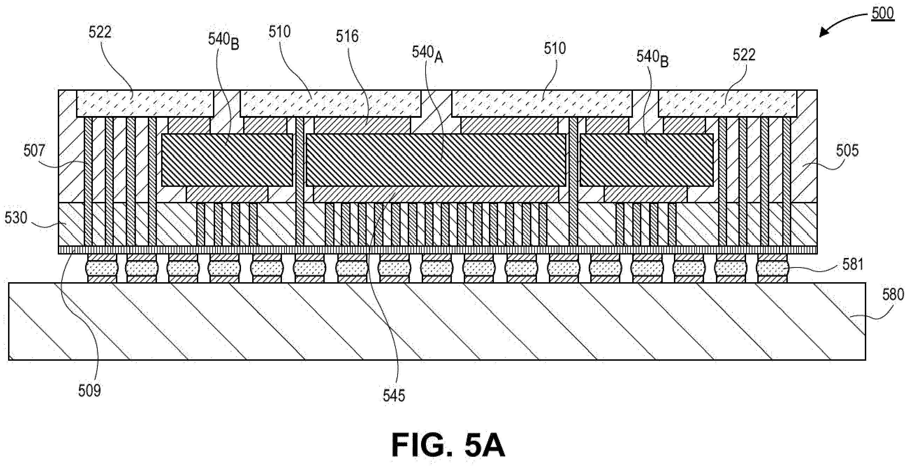

Referring now to Figure 5A, a cross-sectional illustration of a die module 500 is shown, in accordance with an embodiment. In an embodiment, the die module 500 may be coupled to a package substrate 580 by interconnects 581. The die module 500 may comprise a base die 530. The base die 530 may be a semiconductor substrate, such as a silicon substrate or the like. In an embodiment, a redistribution layer 509 may be provided below the base die 530 between the base die 530 and the interconnects 581. The redistribution layer 509 may comprise conductive routing in order to electrically couple vias 507 to pads on the interconnects 581.

In an embodiment, the die module 500 may further comprise disaggregated dies 510. The disaggregated dies 510 may be CPUs, GPUs, or the like. In an embodiment, IO dies 522 may be adjacent to the disaggregated dies 510. In an embodiment, the disaggregated dies 510 may be communicatively coupled together by a communication die 540_{A}. The communication die 540_{A} may be similar to the hub die 440 described in greater detail above. For example, the communication die 540_{A} may include active circuitry in order to accommodate mesh stops and/or fabric interfaces. In some embodiments, transmitters (Tx), receivers (Rx), clocking circuits, matched routing channels, and power delivery units may be provided on the communication die 540_{A}.

In an embodiment, the communication die 540_{A} may be coupled to the disaggregated dies 510 by an interconnect interface 516. While shown as a solid box in order to not overly complicate Figure 5A, it is to be appreciated that the interconnect interface 516 may be any suitable interconnect architecture. In some embodiments, the interconnect interface 516 may be an FLI, such as an HBI interface, similar to the HBI interface illustrated in Figure 3. Similarly, a second interface 545 may be at the bottom of the communication die 540_{A}. The second interface 545 may also be an FLI, such as a HBI interface. The second interface 545 may couple the communication die 540_{A} to underlying vias 507 that pass through the base die 530.

In an embodiment, additional communication dies 540_{B} may provide communicative coupling between the disaggregated dies 510 and the IO dies 522. The communication dies 540_{B} may be substantially similar to the communication die 540_{A}. In other embodiments, the communication dies 540_{B} may only include conductive routing. That is, active circuitry may be omitted from communication dies 540_{B} in some embodiments.

In an embodiment, the die module 500 may be embedded in a mold layer 505. The mold layer 505 may entirely embed the communication dies 540_{A} and 540_{B}. The mold layer 505 may partially embed the disaggregated dies 510 and the IO dies 522. For example, top surfaces of the disaggregated dies 510 and the IO dies 522 may be exposed in some embodiments.

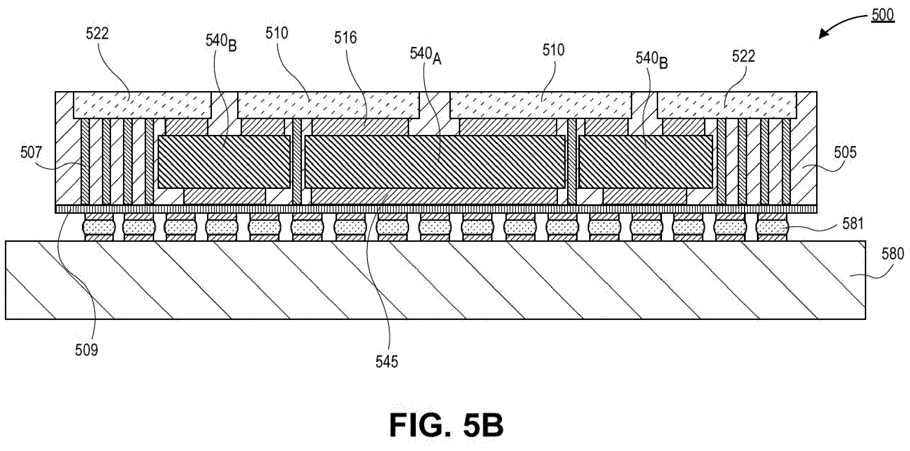

Referring now to Figure 5B, a cross-sectional illustration of a die module 500 is shown, in accordance with an additional embodiment. The die module 500 in Figure 5B may be substantially similar to the die module 500 in Figure 5A, with the exception of the base die 530 being omitted. Instead of being disposed over the base die 230, the redistribution layer 509 may be provided along a bottom surface of the mold layer 505. In an embodiment, the removal of the base die 530 may result in the second interfaces 545 being directly connected to the redistribution layer 509 without any intervening vias. In such an embodiment, the redistribution layer 509 may have an FLI interface to bond with the communication dies 540_{A} and 540_{B}.

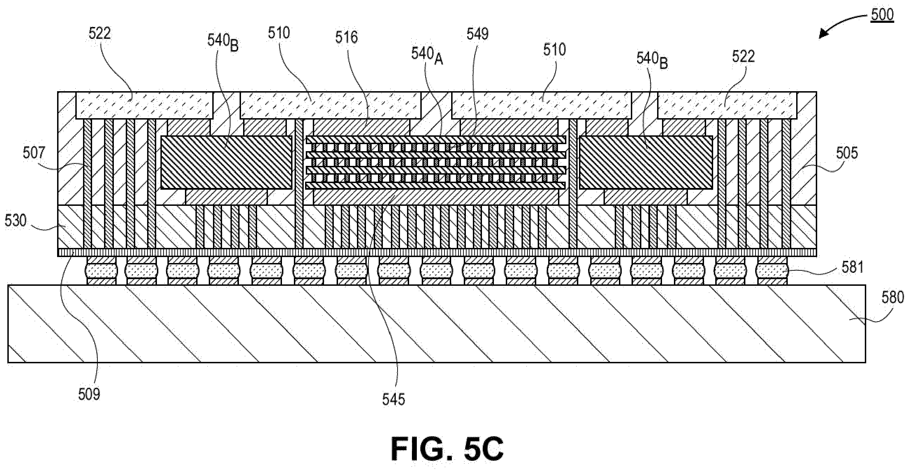

Referring now to Figure 5C, a cross-sectional illustration of a die module 500 is shown, in accordance with an embodiment. In an embodiment, the die module 500 may be substantially similar to the die module 500 in Figure 5A, with the exception of the architecture of the communication die 540_{A}. Instead of providing a single monolithic die, the communication die 540_{A} may be split into a plurality of dies 540_{A} arranged in a stack. The communication dies 540_{A} may be connected to each other by interconnects 549. In an embodiment, the interconnects 549 may be HBI interface interconnects, similar to the embodiment shown in Figure 3.

In an embodiment, one or more of the plurality of dies 540_{A} may include active circuitry. The active circuitry may allow for mesh stops and/or fabric interfaces to be offloaded from the overlying disaggregated dies 510. For example, transmitters (Tx), receivers (Rx), clocking circuits, matched routing channels, and power delivery units may be provided on one or more of the plurality of dies 540_{A}. In an embodiment, the plurality of dies 540_{A} may include memory dies. For example, one or more of the plurality of dies 540_{A} may be L4 cache.

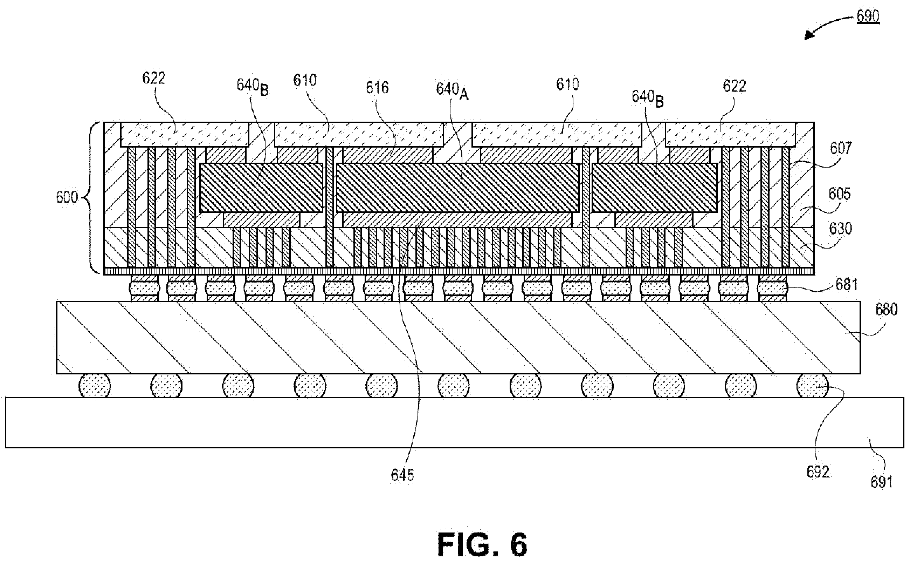

Referring now to Figure 6, a cross-sectional illustration of an electronic system 690 is shown, in accordance with an embodiment. In an embodiment, the electronic system 690 comprises a board 691. The board 691 may be a printed circuit board (PCB) or the like. In an embodiment, the board 691 may be coupled to a package substrate 680 by interconnects 692. The interconnects 692 may be any suitable interconnect architecture. For example, the interconnects 692 may comprise solder bumps. In other embodiments, the interconnects 692 may comprise sockets, or the like. In an embodiment, the package substrate 680 may be coupled to a die module 600 by interconnects 681. The interconnects 681 may be solder bumps or the like.

In the illustrated embodiment, the die module 600 is similar to the die module 500 in Figure 5A. However, it is to be appreciated that the die module 600 may be substantially similar to any of the die modules described in greater detail herein. In the illustrated embodiment, the die module 600 comprises a base die 630. A mold layer 605 is provided over the base die 630.

A plurality of communication dies 640_{A} and 640_{B} are provided in the mold layer 605. The communication dies 640_{A} and 640_{B} may include active circuitry in order to accommodate mesh stops and/or fabric interfaces. For example, transmitters (Tx), receivers (Rx), clocking circuits, matched routing channels, and power delivery units may be provided on the communication dies 640_{A} and 640_{B}. The communication dies 640 may couple together overlying disaggregated dies 610 and/or overlying IO dies 622. In an embodiment, the communication dies 640 are coupled to the disaggregated dies 610 and the IO dies 622 by interconnect interface 616. For example, the interconnect interfaces 616 may comprise FLIs, such as HBI interfaces. In an embodiment, the bottoms of the communication dies 640 may be coupled to vias 607 by interfaces 645, such as HBI interfaces or the like.

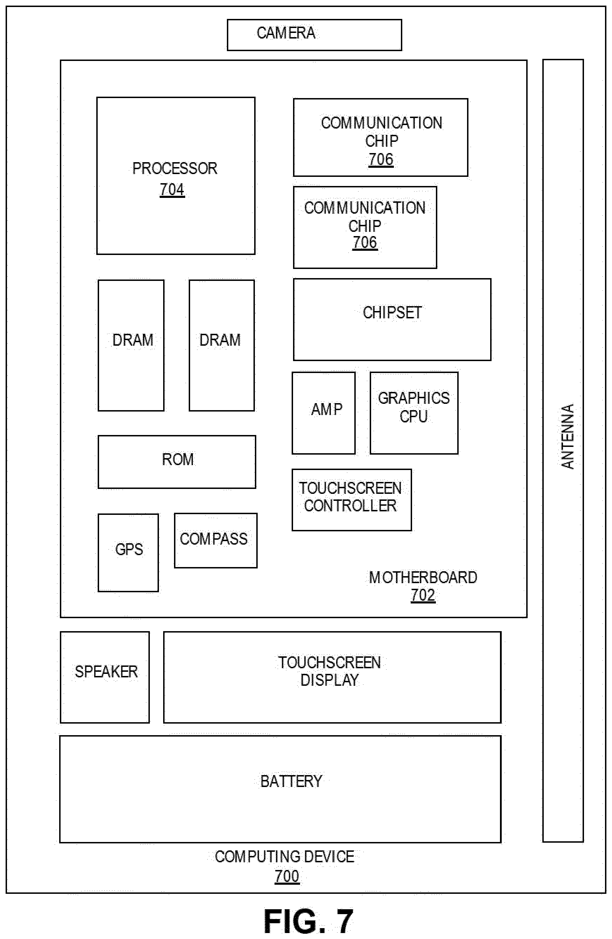

Figure 7 illustrates a computing device 700 in accordance with one implementation of the invention. The computing device 700 houses a board 702. The board 702 may include a number of components, including but not limited to a processor 704 and at least one communication chip 706. The processor 704 is physically and electrically coupled to the board 702. In some implementations the at least one communication chip 706 is also physically and electrically coupled to the board 702. In further implementations, the communication chip 706 is part of the processor 704.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 706 enables wireless communications for the transfer of data to and from the computing device 700. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 706 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 700 may include a plurality of communication chips 706. For instance, a first communication chip 706 may be dedicated to shorter range wireless communications such as Wi-Fi and Bluetooth and a second communication chip 706 may be dedicated to longer range wireless communications such as GPS, EDGE, GPRS, CDMA, WiMAX, LTE, Ev-DO, and others.

The processor 704 of the computing device 700 includes an integrated circuit die packaged within the processor 704. In some implementations of the invention, the integrated circuit die of the processor may be part of an electronic package that comprises a die module with a communication die that includes mesh stops and/or fabric interfaces, in accordance with embodiments described herein. The term "processor" may refer to any device or portion of a device that processes electronic data from registers and/or memory to transform that electronic data into other electronic data that may be stored in registers and/or memory.

The communication chip 706 also includes an integrated circuit die packaged within the communication chip 706. In accordance with another implementation of the invention, the integrated circuit die of the communication chip may be part of an electronic package that comprises a die module with a communication die that includes mesh stops and/or fabric interfaces, in accordance with embodiments described herein.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.

Example 1: a die module, comprising: a plurality of first dies; and a second die under the plurality of first dies, wherein the second die is coupled to individual ones of the plurality of first dies, and wherein the second die comprises: a plurality of mesh stops; and conductive routing to electrically couple the mesh stops together.

Example 2: the die module of Example 1, wherein the individual ones of the plurality of mesh stops are below a corresponding one of the plurality of first dies.

Example 3: the die module of Example 1 or Example 2, wherein the second die is coupled to the plurality of first dies by hybrid bonding interconnect interfaces.

Example 4: the die module of Example 3, wherein the hybrid bonding interconnect interfaces comprise: a plurality of conductive bumps; and a dielectric layer surrounding the conductive bumps.

Example 5: the die module of Examples 1-4, further comprising: a third die below the second die, wherein a footprint of the third die is greater than a footprint of the second die.

Example 6: the die module of Example 5, further comprising: a mold layer around the plurality of first dies and the second die.

Example 7: the die module of Example 6, further comprising: a via through the mold layer, wherein the via connects a first die to the third die.

Example 8: the die module of Examples 1-7, wherein individual ones of the mesh stops comprise one or more of a transmitter circuitry, a receiver circuitry, a clock circuitry, and power delivery circuitry.

Example 9: the die module of Examples 1-8, further comprising: a memory block on the second die.

Example 10: the die module of Example 9, wherein the memory block is an L4 cache.

Example 11: the die module of claim Examples 1-10, wherein the plurality of first dies have an outer perimeter, and wherein the second die is entirely within the outer perimeter.

Example 12: a die, comprising: a substrate, wherein the substrate comprises a semiconductor material; a plurality of mesh stops on the substrate; and conductive routing to electrically couple the mesh stops together.

Example 13: the die of Example 12, wherein individual ones of the mesh stops comprise one or more of a transmitter circuitry, a receiver circuitry, a clock circuitry, and power delivery circuitry.

Example 14: the die of Example 12 or Example 13, further comprising: a memory block on the substrate.

Example 15: the die of Example 14, wherein the memory block is an L4 cache.

Example 16: the die of Examples 12-15, wherein the die comprises an interconnect interface configured to connect with a second die.

Example 17: the die of Example 16, wherein the interconnect interface is a hybrid bonding interconnect interface.

Example 18: the die of Example 17, wherein the hybrid bonding interconnect interface comprises: a plurality of conductive bumps; and a dielectric layer surrounding the conductive bumps.

Example 19: the die of Examples 12-18, wherein the conductive routing is a fabric loop for coupling together the plurality of mesh stops.

Example 20: the die of Examples 12-19, wherein the die comprises an active circuitry layer, wherein the mesh stops are in the active circuitry layer.

Example 21: the die of Example 20, further comprising vias into the die, wherein the vias electrically couple the active circuitry layer to a surface of the die.

Example 22: an electronic system, comprising: a board; a package substrate coupled to the board; and a die module coupled to the package substrate, wherein the die module comprises a plurality of first dies that are communicatively coupled together by a second die, wherein mesh stops and routing circuitry is provided on the second die.

Example 23: the electronic system of Example 22, wherein the routing circuitry comprises one or more of a transmitter circuitry, a receiver circuitry, a clock circuitry, and power delivery circuitry.

Example 24: the electronic system of Example 22 or Example 23, wherein the die module further comprises: a third die, wherein the second die is between the plurality of first dies and the third die.

Example 25: the electronic system of Examples 22-24, wherein the second die further comprises memory blocks.

## Claims

1. A die module, comprising:
a plurality of first dies; and
a second die under the plurality of first dies, wherein the second die is coupled to individual ones of the plurality of first dies, and wherein the second die comprises:
a plurality of mesh stops; and
conductive routing to electrically couple the mesh stops together.

2. The die module of claim 1, wherein the individual ones of the plurality of mesh stops are below a corresponding one of the plurality of first dies.

3. The die module of claim 1 or 2, wherein the second die is coupled to the plurality of first dies by hybrid bonding interconnect interfaces.

4. The die module of claim 3, wherein the hybrid bonding interconnect interfaces comprise:
a plurality of conductive bumps; and
a dielectric layer surrounding the conductive bumps.

5. The die module of claim 1, 2, 3 or 4, further comprising:
a third die below the second die, wherein a footprint of the third die is greater than a footprint of the second die.

6. The die module of claim 5, further comprising:
a mold layer around the plurality of first dies and the second die.

7. The die module of claim 6, further comprising:
a via through the mold layer, wherein the via connects a first die to the third die.

8. The die module of claim 1, 2, 3, 4, 5, 6 or 7, wherein individual ones of the mesh stops comprise one or more of a transmitter circuitry, a receiver circuitry, a clock circuitry, and power delivery circuitry.

9. The die module of claim 1, 2, 3, 4, 5, 6, 7 or 8, further comprising:
a memory block on the second die.

10. The die module of claim 9, wherein the memory block is an L4 cache.

11. The die module of claim 1, 2, 3, 4, 5, 6, 7, 8, 9 or 10, wherein the plurality of first dies have an outer perimeter, and wherein the second die is entirely within the outer perimeter.

12. A method of fabricating a die module, the method comprising:
providing a plurality of first dies; and
providing a second die under the plurality of first dies, wherein the second die is coupled to individual ones of the plurality of first dies, and wherein the second die comprises:
a plurality of mesh stops; and
conductive routing to electrically couple the mesh stops together.

13. The method of claim 12, wherein the individual ones of the plurality of mesh stops are below a corresponding one of the plurality of first dies.

14. The method of claim 12 or 13, wherein the second die is coupled to the plurality of first dies by hybrid bonding interconnect interfaces.

15. The method of claim 12, 13 or 14, wherein individual ones of the mesh stops comprise one or more of a transmitter circuitry, a receiver circuitry, a clock circuitry, and power delivery circuitry.
